# EUROPEAN PATENT APPLICATION

(11) **EP 3 640 374 A1**
(43) Date of publication of application: **22.04.2020**
(21) Application number: 18817489.0
(22) Date of filing: 15.06.2018
(51) Int. Cl.: C30B 25/18, C30B 29/60

(54) **STRETCHABLE CRYSTALLINE SEMICONDUCTOR NANOWIRE AND PREPARATION METHOD THEREOF**

(30) Priority: 15.06.2017 CN 201710450420; 14.06.2018 CN 201810614845
(71) Applicant: Nanjing University, Jiangsu 210093 (CN)
(72) Inventor: YU, Linwei, Jiangsu 210093 (CN); XUE, Zhaoguo, Jiangsu 210093 (CN); DONG, Taige, Jiangsu 210093 (CN); WANG, Junzhuan, Jiangsu 210093 (CN)
(74) Representative: Gong, Jinping
(86) International application number: PCT/CN2018/091544
(87) International publication number: WO 2018/228543

(57) **Abstract**

A stretchable crystalline semiconductor nanowire and a preparation method thereof are provided. The stretchable crystalline semiconductor nanowire has a long and thin main body, a diameter of the nanowire is between 20 to 200 nm, and the nanowire has a crystalline inorganic semiconductor structure. The stretchable crystalline semiconductor nanowire has a bending structure having a plurality of stretchable units disposed along an axial direction, and the stretchable units are connected sequentially to form the stretchable crystalline semiconductor nanowire. A channel step-guided nanowire is grown by PECVD adopting a method such as IP-SLS, and a crystalline nanowire array having a spring structure is manufactured using modern micromachining technology. Since the nanowire and the guided channel cross-section can be effectively adjusted, stripping and transferring onto other flexible substrates can be further performed. The method of preparing a crystalline nanowire having a spring structure has broad prospects in applications related to the fields of flexible electronics and sensors. A stretchable crystalline semiconductor nanowire and a preparation method thereof are provided. The stretchable crystalline semiconductor nanowire has a long and thin main body, a diameter of the nanowire is between 20 to 200 nm, and the nanowire has a crystalline inorganic semiconductor structure. The stretchable crystalline semiconductor nanowire has a bending structure having a plurality of stretchable units disposed along an axial direction, and the stretchable units are connected sequentially to form the stretchable crystalline semiconductor nanowire. A channel step-guided nanowire is grown by PECVD adopting a method such as IP-SLS, and a crystalline nanowire array having a spring structure is manufactured using modern micromachining technology. Since the nanowire and the guided channel cross-sec.

## Description

### Priority Declaration

This application is a partial extension of the CN201710450420.3 (public no. CN107460542A) submitted on June 15, 2017, which requires priority, and its entire content is hereby incorporated into this article by way of quotation.

### Technical Field

The invention relates to the field of flexible stretchable electronics and devices, and relates to a fabrication method for forming a spring structure crystal nanowires with flexible and stretchable properties on a substrate by using a channel-guided planar nanowires growth technology through a micro-machining process. In particular, the method of channel-guided self-localization and self-directional growth, transfer and electrical integration of planar semiconductor nanowires is used to prepare spring-structured crystal nanowires.

### Background Technology

With the development of the contemporary electronic display industry, flexible and stretchable electronics (especially display device) for easier to meet the demand of practical application and material characteristics of flexible itself, in the modern science and technology, national economy and all aspects of daily life play an increasingly important role in the field of the study, the growth of material preparation technology has an important position.

SLS Growth Mechanism: The SLS growth mechanism is similar to VLS. The difference between SLS and VLS is that the raw materials required are provided by the gas phase during the growth process of VLS mechanism. In the SLS growth mechanism, the raw materials are provided from the solution. In general, the low-melting point metal (such as In, Sn, Bi, etc.) is used as the fluxdroplet, which is equivalent to the catalyst in the VLS mechanism.

Due to its extensive industrial base, mature technology and semiconductor preparation technology, as well as similar properties of carbon based materials constructed by human body, it is harmless to human body, and nanoscale silicon materials are easy to degrade. Therefore, the combination of silicon based nanotechnology and flexible stretch-able electronic field will achieve great utility.

The growth of stretchable crystal nanowire spring structure is the foundation of flexible and stretchable electronic devices. But there's not yet a good way to solve the problem.

### The Invention Content

The purpose of the present invention is to provide a stretchable crystalline semiconductor nanowires and a preparation method. In particular, planar semiconductor nanowires are fabricated by directional growth, transfer and integration methods along specific guidance channels.

According to one aspect of the invention, the invention provides a stretchable crystalline semiconductor nanowire:
The stretchable crystal semiconductor nanowires have a slender main body, the diameter of the nanowires is between 20-200 nanometers, and the nanowires are crystalline inorganic semiconductor structures.

The stretchable crystalline semiconductor nanowires have a curved structure and a plurality of stretchable elements in the axial direction. The stretchable elements are connected in turn to form stretchable crystalline semiconductor nanowires.

Further, the stretchable elements of the stretchable crystalline semiconductor nanowires are one or more combinations of circular arc, semicircle, semi-runway, Z-shaped, V-shaped, and M-shaped.

Further, the length in the maximum tensile state is 1.5 times larger than that in the natural state, more than 2 times will be better, and the preferred length is 2.7 times.

In one embodiment, a crystal nanowire is grown that is a single crystal nanowire such as Si, SiGe, Ge, or GaAs.

According to another aspect of the invention, the invention provides a preparation method for stretchable crystal semiconductor nanowires, which includes the following steps:
1) Using a substrate including glass, silicon dioxide or silicon wafer to remove the surface residue of the substrate;
2) A step with a certain depth is etched on the surface of the substrate, and then a specific guide channel is fabricated along the step;
3) Through the method of plane nanowire guiding growth, the crystal nanowires grow accurately along the guided channel, and the catalytic metal film block is evaporated and deposited at one end of the guiding channel as the initial point of metal droplet formation and the starting position of nanowires;
4) Treat a metallic film with a reducing plasma including hydrogen in a PECVD system, remove an oxide layer on the surface, and make it a nanometallic catalytic particle with a diameter between tens nanometers and one micron;
5) Deposit an amorphous semiconductor layer with an appropriate thickness as a precursor medium;
6) The growth is carried out in a vacuum or non-oxidizing atmosphere, the temperature is above 250°C, so that the metal liquid drops start to move along the guided step, the amorphous layer is absorbed and a crystalline nanowire structure is deposited along the way.

Further, in step 1,the silicon wafer is a P-type or N-type single crystal or a polysilicon wafer covering on the surface with dielectric layers such as silicon dioxide or silicon nitride. Glass is ordinary glass or quartz glass. The polymer can be a flexible polymer which can withstand a certain high temperature (> 350 °C) and is compatible with vacuum environment. The thickness of the described silicon dioxide substrate is more than 250nm.
1. Further, the step 5 includes to reuse the PECVD system to cover an amorphous semiconductor layer with an appropriate thickness as a precursor medium; For crystal silicon of growth, crystal germanium, or crystalline germanium silicon alloy nanowires, amorphous silicon, amorphous germanium and amorphous silicon germanium layers were used as precursors correspondingly. For other semiconductor materials, the corresponding amorphous film is used as a precursor.

In an embodiment, it also includes step 7, which is to prepare electrode by photolithography and evaporation.

In an embodiment, it also includes the following steps:
Step 8, separate the nanowires from the substrate by etching the liquid.
Step 9, the detached spring nanowire array is transferred to a flexible substrate, which can be any substrate with tensile properties.

The substrate used for growth may be P-type or N-type monocrystalline silicon substrate with silicon dioxide layer on the surface. It can be P-type or N-type polysilicon with silicon dioxide layer on the surface. It can also be ordinary glass, quartz glass and other amorphous substrate.

The guided channel is made by photolithography. The etching method is wet etching: alkaline corrosion systems such as KOH and NaOH, or acid corrosion systems such as HF+HNO3 and HF+HNO3+CH3COOH, or Ethylene Diamine Pyrocatechol and other systems. Or using dry etching, that is, etching with ICP-RIE.

The metal electrode used PT(12nm) -AL (80nm) system, which could be Ti-Au system and Ni metal. The contact performance of the metal contact was improved through rapid thermal annealing process. Thermal evaporation systems, magnetron sputtering systems or electron beam evaporation systems can be used.

The surface of the substrate is corroded by etching liquid, so that the crystal nanowires with spring structure can be separated from the substrate and it can facilitate the completion of transfers.

Crystal nanowires with spring structure are flexible and high performance devices with high stretch-ability.

### The Beneficial Effects of The Invention

The invention adopts IP-SLS and other methods to grow nanowires guided by channel steps in PECVD, and makes use of modern micro-machining technology to fabricate spring structure crystal nanowires array. The IP-SLS method can grow a planar nanowire, and can grow a high-quality, specific-shaped planar semiconductor single-crystal nanowire array in combination with the step-channel guiding technology. The self-localization and self-orientation of nanowire growth can be realized by guiding the channel and locating the catalyst region formed by photoetch technology. Because such nanowires and guide channel sections can be effectively regulated, further stripping (such as corrosion stripping) and transfer to other flexible substrates can be performed. The method of preparing spring structure crystal nanowires has a broad prospect in the field of flexible electronics and the application of sensors.

For the first time, the invention makes use of the characteristic that planar nanowires can be guided growth, and the results show the channel alignment design of super flexible nanowires and the structure of crystal semiconductor nanowires that can be stretched. Take crystalline silicon as an example, crystalline silicon itself is not stretchable and brittle, so crystalline silicon film cannot be directly applied to stretchable electronic devices. Through this invention, the existing mature silicon semiconductor technology can be extended to an emerging field of flexible electronic applications, and provide a key technical basis for greatly improving the device characteristics and stability of flexible electronic devices.

### Description of Figures

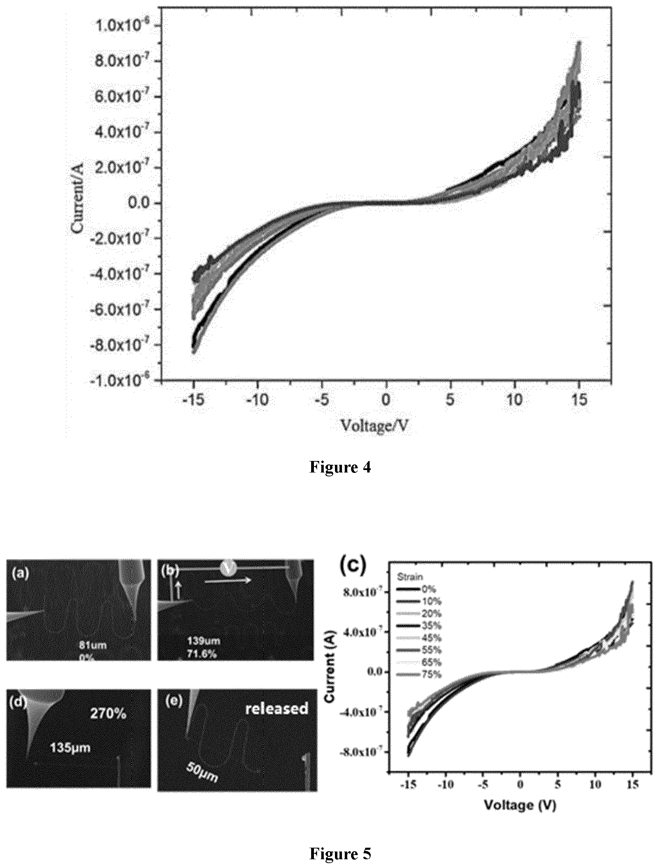

Figure 1 is the flow chart of the preparation process of spring structure crystal nanowires;
Figure 2 is a schematic diagram of crystal nanowire array with spring structure. In Figure 2 of a schematic diagram of a crystal nanowire array with a spring structure, the blue (dark) region is the catalyst region ,and (a)(b)(c)(d) represents four different spring-shaped curves respectively;
Figure 3 shows the SEM topography of crystal nanowires with spring structure.(a) (b) (c) (d) represents four different ratios respectively.
Figure 4 is a diagram of electrical properties of crystal silicon nanowires with spring structure.
   (a) and (b) in figure 5 are examples of in-situ SEM mechanical tensile and synchronous electrical tests of a stretchable silicon nanowire. (c) in figure 5 is synchronous potential test result diagram.(d) and (e) in figure 5 of SEM images of the process by which stretchy silicon nanowires are stretched to the elastic deformation limit of 270% and can be fully recovered.

### Specific Implementation Mode

In order to make the purpose, technical proposal, function and advantages of the invention more clear, the invention is further explained in detail combined with specific examples.

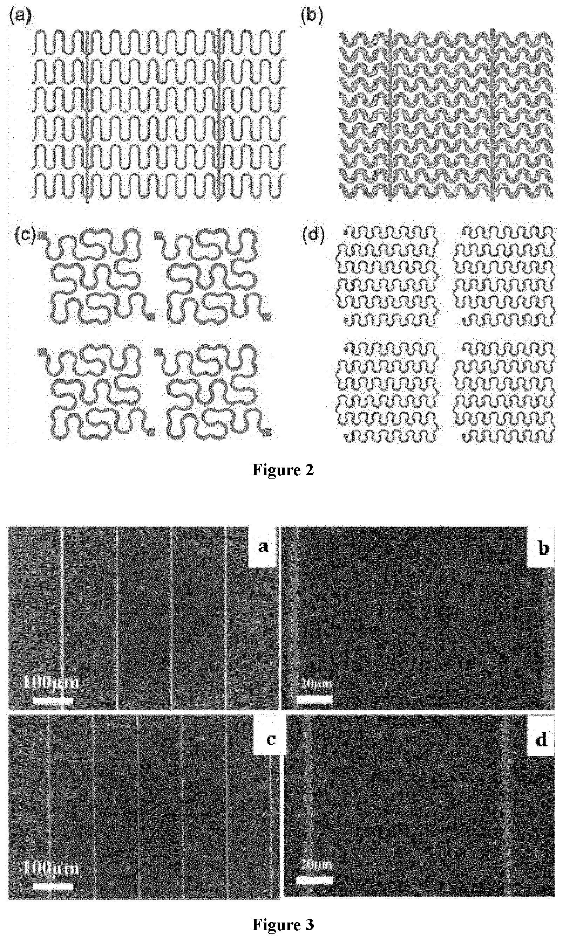

As shown in figure 2, the invention provides a extendable crystal semiconductor nanowire with a slender main body. The stretchable crystalline semiconductor nanowires have a curved structure and a plurality of stretchable elements in the axial direction. The stretchable elements are connected in turn to form stretchable crystalline semiconductor nanowires.

Further, the diameter of the nanowire is between 20 and 200 nanometers, and the nanowire is a crystal inorganic semiconductor structure.

As shown in Figure 2, the crystal nanowire array is designed in which the blue (dark) region (a) (b) (c) (d) represents four different spring curves. From the diagram, it can be seen that the nanowires are curved structure and have a number of interrelated tensionable elements in the axial direction, and the extendable elements are one or more of the circular arc, semicircular and semi-racetrack shapes.

Further, the stretchable elements of the stretchable crystalline semiconductor nanowires are circular, semicircular, or semi-racetrack, or z-shaped, v-shaped, m-shaped (not shown), or one or more of these combinations.

Furthermore, the length of the maximum tensile state is 1.5 times larger than that of the natural state, more than 2 times will be better, and the preferred length is 2.7 times.

In one embodiment, a crystal nanowire is grown that is a single crystal nanowire such as Si, SiGe, Ge, or GaAs.

The substrate used for growth may be P-type or N-type monocrystalline silicon substrate with silicon dioxide layer on the surface. It can be P-type or N-type polysilicon with silicon dioxide layer on the surface. It can also be ordinary glass, quartz glass and other amorphous substrate.

Figure 3 shows the SEM topography of crystal nanowires with spring structure.

Figure 4 shows the electrical properties of the crystal silicon nanowires with spring structure.

As an example of Figure 5 (a) (b), one of the silicon nanowires is mechanically stretched under the operation of a mechanical probe in in situ scanning electron microscope (SEM) and its synchronous electrical test is carried out. The test results, as shown in Figure 5 (c), show that the electrical properties of silicon nanowires are stable during tensile elastic deformation.

As shown in figure 5 (d) (e), the silicon nanowires can be mechanically stretched to the limit. The maximum tensile length of the nanowires is larger than 270% of the natural length, and the elastic deformation is maintained. After release, the silicon nanowires can be restored to their original shape.

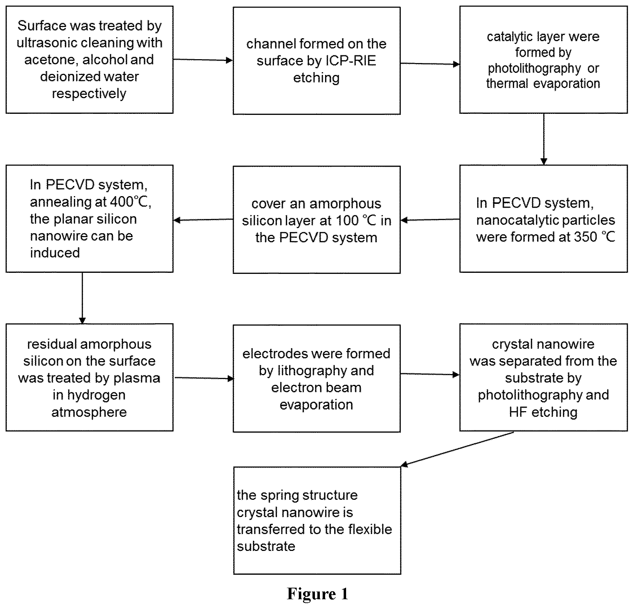

According to another aspect of the invention, as shown in fig. 1, the invention provides a method for preparing extruded crystal semiconductor nanowires based on the linear design and guidance of planar nanowires. The characteristic steps include:
1) Standardized cleaning of substrates such as glass, silica or silicon wafer is used to remove organic matter and metal residues on the surface;
2) The linear shape of the guided step can be designed and defined freely and conveniently. In order to realize the stretchable flexible crystalline semiconductor channel structure, the step alignment is designed as a non-linear curved spring or zigzag serpentine channel array, and a depth of about 150±10 nm (less than 350 nm) spring-guided channel array and a more spatial relaxation single-wire-connected two-dimensional curved fractal structure are fabricated by lithography etching on the substrate.
3) The crystal nanowires with a diameter of about 120 ±10nm are precisely grown along the guided channel to form a nanowire spring array by the plane nanowire guide growth method.; that is, the catalytic metal film block is deposited at one end of the guide channel by lift-off or mask technology, which is used as the initial point of metal droplet formation and the starting position of the nanowires.
4) The metal thin films were treated by reducing plasma such as hydrogen in PECVD system, and the oxide layer on the surface was removed, and the diameters ranging of the nanometer metal catalytic particles were formed from tens of nanometers to one micron.
5) Deposit an amorphous semiconductor layer covering an appropriate thickness as a precursor medium;
6) Annealing in vacuum or non-oxidizing atmosphere (above 250 °C) makes the metal droplets begin to move along the guiding steps, absorb the amorphous layer and deposit the crystal nanowire structure along the way.
7) The electrodes were prepared at both ends of the nanowire spring array by photolithography and evaporation.
8) The nanowire spring is detached from the substrate by etched the liquid.
9) By transferring the detached spring nanowire array to a flexible substrate, a stretchable nanowire spring can be fabricated, which can be widely used in flexible electronics. Flexible nanowire springs or related structures can be transferred into a flexible stretchable polymer substrate (spin-coated film through the sample surface and coupled with sacrificial layer corrosion transfer, as well as direct manipulation using nano-machines).

Further, the substrate characterized in step (1) may be silicon wafer, glass, ceramic wafer and polymer substrate that can withstand high temperature to 350 °C. The described silicon dioxide substrate is a common silicon dioxide substrate with a thickness of more than 250 nm. The silicon wafer can also be a P-type or N-type single crystal or polysilicon wafer covered with silicon dioxide or silicon nitride dielectric layer. The glass is ordinary glass or quartz glass. The polymer can be a flexible polymer which can withstand a certain high temperature (> 350 °C) and is compatible with the vacuum environment.

Further, in step 3, the photolithography alignment technique is used again to guide the growth method of crystal nanowires with a diameter of about 130 ±10nm to form spring-shaped nanowires in the catalyst region at the channel position.; The evaporation of In,Sn metal is to guide the channel specific position to form dozens of nanowires of metal film patterns. In PECVD system, plasma treatment technology was used at 350 °C and power 2-5W to make the metal film shrink spheres form quasi-nanometer catalytic particles with diameters ranging from hundreds of nanometers to a few micrometers, and then use PECVD system to cover a layer of amorphous silicon with appropriate thickness (a few nanometers to hundreds of nanometers) as the precursor dielectric layer, annealed at 350 °C in vacuum atmosphere, and use IP-SLS growth mode to make the nanowires grow along the guide channel from the catalyst region to form and obtain spring nanowires.

Further, the catalytic metals characterized in step (3) may be low melting point metals indium, tin, gallium, lead, bismuth, etc., as well as their alloys and oxide materials, and precious metals such as gold, silver, copper, etc., which match with the grown crystal nanowire materials.

Further, the characteristic steps in step (2) include: firstly, define the guided step alignment of planar nanowires in the photoresist layer using photolithography, and then etching the pattern downward into the substrate using RIE or ICP etching techniques at depths ranging from a few to hundreds of nanometers;

In an embodiment, a guide channel is made by a photolithography etch method, wherein an etching method is use in a wet etch: a basic corrosion system such as potassium hydroxide (KOH), sodium hydroxide (NaOH), or hydrofluoric acid + nitric acid (HF + HNO3), the acid corrosion system, such as hydrofluoric acid + nitric acid + acetic acid (HF + HNO3 + CH3COOH), can also be a system such as ethylene diamine pyrocatechol, or can be etched by using ICP-RIE.

In an embodiment, spring crystal nanowires are grown, and the nanowires are Si,Ge,SiGe,GaAs and other crystal materials. Using any shape structure with tensile properties, the diameter of crystal nanowires is 20-180 nm.

Further, the characteristic steps in step (3) include: use photolithography or mask technology, using metal catalytic layer through thermal evaporation, magnetron sputtering, electron beam sputtering, pulse laser sputtering and atomic layer deposition, evaporating indium, tin and other catalytic metal layer films to form several micron metal film regions, and intersecting with the guiding steps at a specific starting position of the guide channel.

Further, step (4) includes the use of plasma treatment in the PECVD system with power between 0.2 to 100 watts in the temperature range of 200°C to 450°C, allowing the metal film to shrink to form nanocatalytic particles ranging in diameter from tens of nanometers to a few micrometers;

Further, the characteristic steps in step (5) include using the PECVD system to cover a layer of amorphous semiconductors of appropriate thickness (a few nanometers to hundreds of nanometers) as the precursor dielectric layer again. For the growth of crystal silicon, crystal germanium or crystalline germanium silicon alloy nanowires, amorphous silicon, amorphous germanium and amorphous germanium silicon layers are used as precursors. For other semiconductor materials, the corresponding amorphous film is used as precursor.

Further, in step (6): for different semiconductor materials, the growth temperature of planar nanowires is chosen between 300°c and 600°c. The nanowire growth process can be carried out under inert gas, reducing gas or vacuum conditions.

Further, in step (7), the plane nanowires are controlled by the edge of the guided step, and the programmable non-linear bending spring or zigzag serpentine channel, as well as the single-wire connected fractal bending two-dimensional distribution structure, can be obtained to realize the tensioned silicon semiconductor nanowire channel.

In another embodiment, the fabrication method of expandable electronic devices of crystal semiconductors (including silicon, germanium, etc.) is realized based on the linear design and guided growth technology of planar nanowires. Using conventional lithography, etch technology, or other template and surface processing techniques, guide steps with specific morphology on glass or silicon substrate are fabricated. Amorphous thin films (using amorphous silicon, amorphous germanium and other amorphous inorganic semiconductor materials) are used as precursors to absorb amorphous thin films by metal (indium, tin, gallium, bismuth, etc.).Grow a corresponding nanowire structure of plane crystal (simple substance or alloy). Because the guide step can be programmed freely, the line-shape can be customized and the regular crystal nanowire array can be customized, and then the crystal semiconductor nanowire structure with super extensibility can be prepared. This technology can realize the nano-channel of crystal semiconductor materials such as silicon with high extensibility, and maintain the excellent electrical modulation and device stability of crystal semiconductor materials, so it can realize high performance flexible semiconductor electronic applications (such as stretch logic transistors, display control and actuators, sensing and artificial skin and other emerging fields).

Specifically, the growth, transfer technology of crystal nanowires of a spring structure is a method of directional growth and transfer under a specific channel, and the steps are as follows:
1) The crystal substrate covered with oxide was treated by ultrasonic treatment of acid-base hot solution or acetone, alcohol and deionized water respectively to remove the impurities attached to the surface and expose the clean surface of the crystal.
2) The guided growth channel array with spring structure is defined by lithography technique, and the catalyst region is defined at the specific position of the channel by lithography alignment technique. The photolithography technology (or surface pattern etch technology) is used to form a certain depth of guidance step.
3) By lift-off or mask technology, catalytic metal film blocks are deposited at one end of the guide channel, In,Sn metal is evaporated and only exists in the specific position of the guided channel to form tens of nanometers of metal film patterns.
4) In PECVD system, plasma treatment technology was used at 350 °C and power 2-5W to make the metal film shrink spheres form quasi-nano-catalytic particles with diameters ranging from hundreds of nanometers to a few micrometers.
5) Again, the PECVD system is used to cover a layer of amorphous silicon (a few nanometers to hundreds of nanometers) with appropriate thickness as the precursor dielectric layer.
6) Annealing in vacuum or non-oxidizing atmosphere (above 280 °C) makes the metal droplets begin to move along the guide steps, absorb the amorphous layer and deposit the crystal nanowires along the way, especially in the vacuum atmosphere, annealed at 350 °C, using IP-SLS growth mode, the nanowires grow along a specific guide channel from the catalyst region to form and obtain spring nanowires.
7) Again, using lithography alignment technology and metal evaporation technology, electrodes are mounted at both ends of the nanowire spring array.
8) The sample surface was etched using HF to separate the nanowires and substrate.
9) The nanowire spring array detached from the substrate is transferred to the flexible substrate. The flexible nanowire spring or related structure can be transferred to the flexible extendable polymer substrate (a thin film can be coated on the surface of the sample, combined with the corrosion transfer of the victim layer, and the nano-manipulator can be selected and manipulated directly).

Further, a guided channel having a depth of about 200 nm, a guided channel of the spring structure (see FIG.1), can be made by a photolithography etching, wherein the spring structure may be any curved shape having a stretchable property, and the distance between the nodes may be 200 nm to 50 um. The etching method of the channel can be used for wet etching: an alkaline system such as potassium hydroxide (KOH), sodium hydroxide (NaOH), or an acidic system such as hydrofluoric acid + nitric acid (HF + HNO3), hydrofluoric acid + nitric acid and acetic acid (HF + HNO3 + CH3COOH), or ethylenediamine-catechol (Ethy). lene Diamine Pyrocatechol) and other systems; They can also be a dry etching system using ICP-RIE for etching.

Further, the etched liquid used in the transfer step may be any liquid that can corrode silica slowly or not. The flexible substrate used for transfer can be any substrate with tensile properties.

Further, the plane grown nanowires can be Si,SiGe,Ge,GaAs isoplanar single crystal nanowires array, and the diameter of the nanowires is distributed between 20-200nm.

Further, metal electrodes can be fabricated by photolithography. Thermal evaporation system, electron beam evaporation system and magnetron sputter system can be used in metal electrode contact. PT (12nm)-AL (80nm) system can be used in metal electrode contact, Ti-Au system and Ni metal can be used, and rapid thermal annealing process can be used to improve contact performance of metal electrode contact.

A more specific real-time example: prepare spring crystal nanowires on 300nmSiO2 oxide substrate, including the following steps:
1) The 300nmSiO2 oxide substrate (silicon wafer oxidized by surface) was treated by ultrasonic cleaning with acetone, alcohol and deionized water respectively to remove the impurities attached to the substrate surface. Pure single crystal or polysilicon wafer can be used in silicon wafer.
2) The spring structure pattern is defined on the substrate surface by mask lithography. The channel is formed on the surface by ICP-RIE etching and the array of biological probe channel is formed after cleaning photoresist.
3)In PECVD system, nanocatalytic particles with diameters ranging from hundreds of nanometers to a few microns were formed by plasma treatment at the power of 1-50W, and nanoparticles with diameters of hundreds of nanometers were formed at 350 °C.
4)Continue to cover an amorphous silicon layer of appropriate thickness as a precursor dielectric layer in the PECVD system; An amorphous silicon layer of appropriate thickness is covered at 300°C-400°C. In vacuum or non-oxidizing atmosphere such as hydrogen and nitrogen annealing at 400°C, the catalytic droplet can be activated to absorb the surrounding amorphous silicon, so that the planar silicon nanowire can be induced, and the nanowire will grow along the guide channel sidewall, forming the desired channel.
5) The residual amorphous silicon on the surface was treated by plasma in hydrogen atmosphere for 15 minutes until the surface color returned to normal color.
6) The electrode pattern is defined by lithography again, the 12nm titanium and 60nm gold are evaporated by electron beam evaporation, and then the photoresist and residual metal are washed away.
7) The substrate was etched by PMMA spin coating and 4% HF solution, so that the PMMA thin film was separated from the substrate with crystal nanowire spring array and substrate.
8) The PMMA film and the upper spring structure crystal nanowire are removed by using a PDMS film, and the PMMA film is dissolved by using a solvent, and the spring structure crystal nanowire is transferred to the flexible substrate PDMS.

The present invention can be better realized as described above. For the technical personnel in the field, the change, modification, replacement, integration and variation of these embodiments without deviating from the principle and spirit of the invention still fall within the protection scope of the invention. The invention is not specifically illustrated or defined and is implemented in the prior art.

## Claims

1. A stretchable crystal semiconductor nanowire, which is **characterized in that** the described nanowire has an elongated body, the diameter of the nanowire is between 20 and 200 nanometers, and the nanowire is a crystalline inorganic semiconductor structure.

2. The stretchable crystal semiconductor nanowires according to claim 1 are **characterized in that**: the described nanowires are curved structures with a plurality of stretchable units in the axial direction, and the plurality of stretchable units are connected in turn to form stretchable crystal semiconductor nanowires.

3. The stretchable crystal semiconductor nanowires according to claim 2 are **characterized in that** the described stretchable unit is one or more combinations in circular arc, semicircle, semi-runway, Z-shaped, V-shaped and M-shaped.

4. The stretchable crystal semiconductor nanowires of claim 2 are **characterized in that** the length of the maximum tensile state of the described nanowire is greater than 1.5 times the length in the natural state, and the preferred length is 2.7 times.

5. The stretchable crystal semiconductor nanowires of claim 2 to 4 are **characterized in that** the described nanowires are Si,SiGe,Ge or GaAs single crystal nanowires.

6. A method of preparing stretchable crystal semiconductor nanowires, as described in claim 1, is **characterized by** the following steps:
1) Using a substrate including glass, silicon dioxide or silicon wafer to remove the surface residue of the substrate;
2) A step with a certain depth is etched on the surface of the substrate, and then a specific guide channel is fabricated along the step;
3) Through the method of plane nanowire guiding growth, the crystal nanowires grow accurately along the guided channel, and the catalytic metal film block is evaporated and deposited at one end of the guiding channel as the initial point of metal droplet formation and the starting position of nanowires;
4) Treat a metallic film with a reducing plasma including hydrogen in a PECVD system, remove an oxide layer on the surface, and make it a nonmetallic catalytic particle with a diameter between tens nanometers and one micron;
5) Deposit an amorphous semiconductor layer with an appropriate thickness as a precursor medium;
6) The growth is carried out in a vacuum or non-oxidizing atmosphere, the temperature is above 250°C, so that the metal liquid drops start to move along the guided step, the amorphous layer is absorbed and a crystalline nanowire structure is deposited along the way.

7. According to the preparation method of stretchable crystal semiconductor nanowires described in claim 6,in step 1,the silicon wafer is a P-type or N-type single crystal or a polysilicon wafer covering on the surface with dielectric layers such as silicon dioxide or silicon nitride. Glass is ordinary glass or quartz glass. The polymer can be a flexible polymer which can withstand a certain high temperature (> 350 °C) and is compatible with vacuum environment. The thickness of the described silicon dioxide substrate is more than 250nm.

8. According to the preparation method of stretchable crystal semiconductor nanowires described in claim 6, the step 5 includes to reuse the PECVD system to cover an amorphous semiconductor layer with an appropriate thickness as a precursor medium; For crystal silicon of growth, crystal germanium, or crystalline germanium silicon alloy nanowires, amorphous silicon, amorphous germanium and amorphous silicon germanium layers were used as precursors correspondingly. For other semiconductor materials, the corresponding amorphous film is used as a precursor.

9. According to the preparation method of stretchable crystal semiconductor nanowires described in claim 6, it also includes step 7, which is to prepare electrode by photolithography and evaporation.

10. According to the preparation method of stretchable crystal semiconductor nanowires described in claim 9, which is **characterized by** the following steps:
Step 8, separate the nanowires from the substrate by etching the liquid.
Step 9, the detached spring nanowire array is transferred to a flexible substrate, which can be any substrate with tensile properties.
